# EUROPÄISCHE PATENTSCHRIFT

(11) **EP 0 888 707 B1**
(45) Veröffentlichungstag und Bekanntmachung des Hinweises auf die Patenterteilung: **18.10.2000**
(21) Anmeldenummer: 97915340.0
(22) Anmeldetag: 07.03.1997
(51) Int. Cl.: H05K 7/14

(54) **BAUGRUPPE MIT EINER SCHALTUNGSANORDNUNG**
MODULE WITH A CIRCUIT ARRANGEMENT
MODULE AVEC ENSEMBLE DE CIRCUITS

(30) Priorität: 20.03.1996 DE 19610742
(43) Veröffentlichungstag der Anmeldung: 07.01.1999
(73) Patentinhaber: SIEMENS AKTIENGESELLSCHAFT, 80333 München (DE)
(72) Erfinder: BRÄUNLICH, Michael, D-09113 Chemnitz (DE); MEIER, Frank-Günter, D-09212 Limbach-Oberfrohna (DE); GLÖCKNER, Knut, D-09113 Chemnitz (DE); LOHSE, Ralf, D-09387 Jahnsdorf (DE); FÜGMANN, Frank, D-09114 Chemnitz (DE)
(86) Internationale Anmeldenummer: DE9700448
(87) Internationale Veröffentlichungsnummer: WO9735459

(56) Entgegenhaltungen:
- EP-A- 0 323 579
- EP-A- 0 572 815
- EP-A- 0 654 960

## Beschreibung

Die vorliegende Erfindung betrifff eine elektrische und/oder elektronische Baugruppe mit einer Schaltungsanordnung mit zumindest einer ersten Platine, einer mit der ersten Platine nicht direkt verbundenen zweiten Platine und einer sowohl mit der ersten als auch mit der zweiten Platine verbundenen dritten Platine.

Eine derartige Baugruppe ist grundsätzlich z.B. aus der EP-A-0 572 815 bekannt.

Bei einer Baugruppe der Eingangs genannten Art, bei der die erste Platine eine Terminalplatine, die zweite Platine eine Logikplatine und die dritte Platine eine Verbindungsplatine ist, ist die ordnungsgemäße Funktion der Logikschaltung prinzipiell durch elektromagnetische Strahlung gefährdet.

Gegenüber der elektromagnetischen Strahlung entfernter Strahlungsquellen läßt sich eine solche Baugruppe in ausreichendem Maße in an sich bekannter Weise durch entsprechende Abschirmung schützen.

An den zur Schaltungsanordnung gehörenden Anschlußmitteln liegen jedoch üblicherweise Signalspannungen von einem bzw. für einen externen Prozeß - also Eingangssignale von externen Sensoren bzw. Ausgangssignale für externe Aktoren - an. Durch die anliegende Signalspannung ergibt sich erneut eine Gefährdung der Logikschaltung durch elektromagnetische Strahlung. Dies aus dem Grunde, weil sich die Signalspannung der Sensoren oder Aktoren u.U. erheblich von einer weiteren Signalspannung, mit der die Signale in der Logikschaltung verarbeitet werden, unterscheidet.

Weiterhin ist bei einer Baugruppe der Eingangs genannten Art die Funktion der Anschlußmittel durch die fest vorgegebenen elektrisch leitenden Verbindungen zwischen Logikschaltung und Anschlußmitteln festgelegt.

Im Falle einer gewünschten Änderung der Funktion der Anschlußmittel ist bisher stets zumindest eine Änderung der Logikschaltung erforderlich.

Die Aufgabe der vorliegenden Erfindung besteht daher darin, einerseits mögliche Störungen durch elektromagnetische Strahlung auf ein Minimum zu begrenzen und damit eine hohe elektromagnetische Verträglichkeit (EMV) der Baugruppe zu gewährleisten, sowie andererseits die Funktion der Anschlußmittel mit Hilfe der Verbindungen zwischen Logik-schaltung und Anschlußmitteln festzulegen, ohne daß dazu die Logikschaltung geändert werden muß.

Die Aufgabe wird mit einer Baugruppe mit den Merkmalen des Anspruchs 1 gelöst.

Mit der Aufteilung der Schaltungsanordnung auf räumlich voneinander getrennte Platinen ist die gewünschte elektromagnetische Verträglichkeit erreicht. Durch die räumliche Trennung ist eine Beeinträchtigung der Funktion der Logikschaltung durch an den Anschlußmitteln der Terminalplatine anstehende Signalspannungen weitestgehend ausgeschlossen.

Die Funktion der Anschlußmittel ist durch die Zwischenschaltung auf der Verbindungsplatine festgelegt. Mit Hilfe von austauschbaren Verbindungsplatinen, die jeweils eine unterschiedliche Zwischenschaltung aufweisen, läßt sich damit die Funktion der Anschlußmittel auf einfache Weise flexibel gestalten.

Die Terminalplatine ist wahlweise entweder auch in dem gemeinsamen Gehäuse oder in einem separaten Gehäuse angeordnet.

In einer weiteren vorteilhaften Ausgestaltung der vorstehend beschriebenen Baugruppe ist mittels einer Zwischenschaltung auf der Verbindungsplatine eine Signalspannungsumsetzung zwischen einer Logikplatinen-Signalspannung, mit der die elektrischen Signale auf der Logikplatine verarbeitet werden, und einer Terminalplatinen-Signalspannung, mit der die Signale auf der Terminalplatine verarbeitet werden, realisiert. Die Bereiche unterschiedlicher Signalspannung bleiben räumlich eindeutig voneinander getrennt. Insbesondere muß die Signalspannungsumsetzung weder auf der Logikplatine noch auf der Terminalplatine realisiert werden, so daß die elektromagnetische Verträglichkeit der Schaltungsanordnung nicht beeinträchtigt wird.

Dadurch, daß die Verbindungsplatine die Funktion der Anschlußmittel festlegt, wird evtl. ein wiederholtes Einstecken und Lösen der Verbindungsplatine erforderlich. Die elektrische Verbindung zwischen der Verbindungsplatine und der Terminalplatine einerseits sowie zwischen der Verbindungsplatine und der Logikplatine andererseits ist daher vorzugsweise durch direkte und/oder indirekte Steckverbinder, insbesondere SMD-Steckverbinder, hergestellt. Die Verbindung ist damit jederzeit wieder lösbar bzw. wieder herstellbar, z.B. bei Reparaturen.

Der innerhalb der Baugruppe zur Verfügung stehende Raum kann besonders effizient ausgenutzt werden, wenn Logikplatine und Terminalplatine höhenversetzt in zueinander parallelen Ebenen angeordnet sind, wobei die Verbindungsplatine sowohl auf der Terminalplatine als auch auf der Logikplatine im wesentlichen senkrecht steht, so daß eine Ausbildung von Stauwärmebereichen vermieden wird.

Es ist zweckmäßig, wenn die Terminalplatine im wesentlichen nur die Anschlußmittel für von außen heranführbare Leitungen und insbesondere keine Logikschaltung aufweist und die Logikplatine im wesentlichen nur die Logikschaltung und insbesondere keine Anschlußmittel für von außen heranführbare Leitungen aufweist, denn damit ergeben sich innerhalb der Baugruppe voneinander abgegrenzte Funktionsbereiche. Diese Auslegung ist insbesondere im Hinblick auf mögliche Störungen und die dadurch bedingten evtl. Wartungserfordernisse sowie auf notwendige Änderungen der Anlagenkonfiguration vorteilhaft. Weiterhin ist durch die beschriebene Ausbildung der Platinen eine effiziente und damit kostengünstige Fertigung realisierbar. Schließlich ermöglicht die beschriebene Ausbildung eine einfache Realisierung einer großen Vielfalt von Anlagenkonfigurationen unter Verwendung einer Anzahl von weitgehend standardisierten Komponenten.

Weitere Vorteile und erfinderische Einzelheiten ergeben sich aus der nachfolgenden Beschreibung eines Ausführungsbeispiels anhand der Zeichnungen und in Verbindung mit den Unteransprüchen. Im einzelnen zeigen:
- FIG 1: eine vereinfachte schematische Darstellung der Schaltungsanordnung gemäß der Erfindung,
- FIG 2: eine Logikplatine, bei der als Steckverbinder SMD-Steckverbinder aufgebracht sind, und
- FIG 3: eine zusammengesteckte Schaltungsanordnung gemäß FIG 1 in der Seitenansicht.

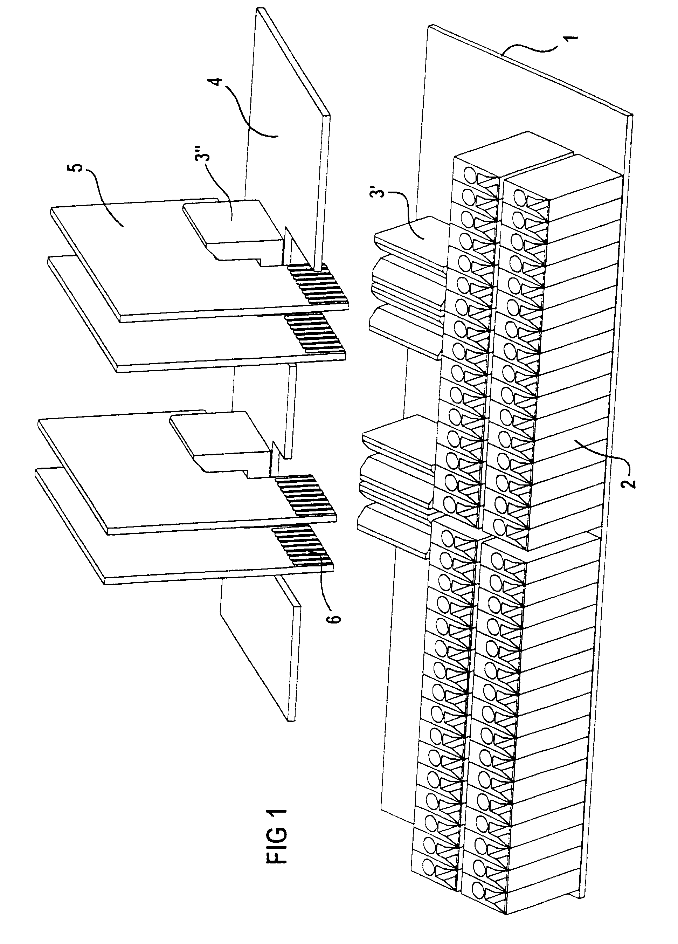

In FIG 1 sind auf der Terminalplatine 1 Anschlußmittel 2 sowie Steckverbinder 3' aufgebracht. Auf der Logikplatine 4 befinden sich nicht dargestellte Logikschaltungen sowie Steckverbinder 3". In die Steckverbinder 3" der Logikplatine 4 sind Verbindungsplatinen eingesteckt. Auf den Verbindungsplatinen 5 befindet sich jeweils eine nicht dargestellte Zwischenschaltung, mit der die Funktion der Anschlußmittel 2 der Terminalplatine 1 festgelegt ist. Die Verbindungsplatinen 5 weisen an ihren unteren Enden Kontaktbahnen 6 auf, die mit entsprechenden Kontaktelementen der Steckverbinder 3', 3" zusammenwirken. Die Verbindungsplatinen stellen somit die elektrische Verbindung zwischen den Zwischenschaltungen auf der Verbindungsplatine 5 und den Anschlußmitteln 2 auf der Terminalplatine 1 einerseits sowie der nicht dargestellten Logik-schaltung auf der Logikplatine 4 andererseits her.

Wie man weiterhin aus FIG 1 erkennt, sind die Verbindungsplatinen 5 jeweils paarweise angeordnet, so daß die Anzahl der innerhalb der Baugruppe verwendeten Verbindungsplatinen 5 insgesamt geradzahlig ist. Die in Gruppen zu jeweils zwei Verbindungsplatinen 5 angeordneten Verbindungsplatinen 5 sind so ausgebildet, daß sie elektrisch und mechanisch austauschbar sind. Das heißt, das Layout und die Anzahl der Kontaktbahnen 6 der Verbindungsplatinen 5 ist bei den Verbindungsplatinen 5 jeweils identisch, so daß einerseits ein Einstecken der Verbindungsplatine 5 auch in andere Steckverbinder 3', 3" mechanisch möglich ist, und daß andererseits dabei stets die Kontaktbahnen 6 und entsprechende Kontaktelemente der Steckverbinder 3', 3" so zusammenwirken, daß die elektrisch leitende Verbindung hergestellt ist. Ein Austauschen der beiden Paare von Verbindungsplatinen 5 der FIG 1 würde bewirken, daß entsprechend auch die Funktion der Anschlußmittel 2 der Terminalplatine 1 wechselt.

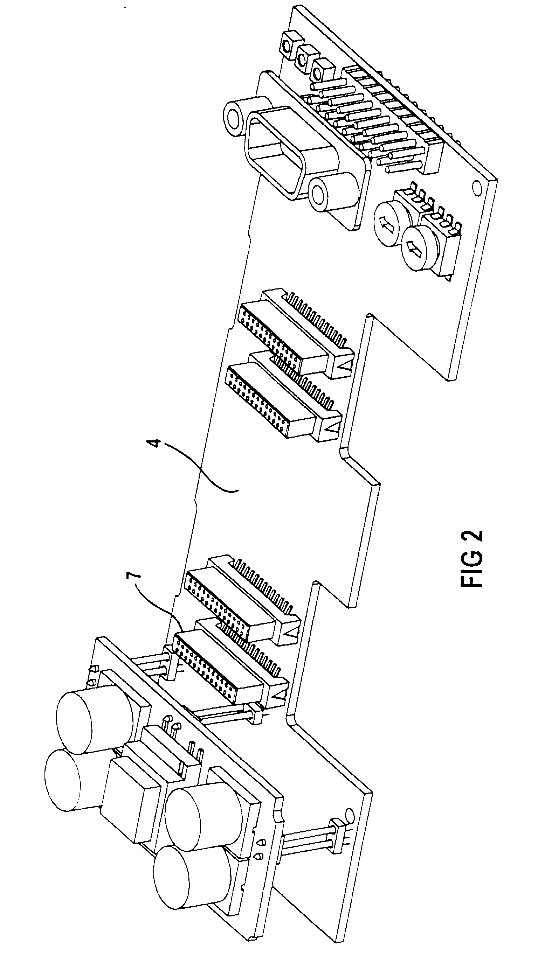

In FIG 1 sind als Steckverbinder 3', 3" direkte Steckverbinder 3', 3" dargestellt. Alternativ können auch - gemäß FIG 2 - indirekte Steckverbinder 7, insbesondere SMD-Steckverbinder 7 zum Einsatz kommen. In einem solchen Falle weisen die Verbindungsplatinen 5 anstelle der Kontaktbahnen 6 Steckverbinderelemente auf, die ein Einstecken in entsprechende indirekte Steckverbinder 7 auf der Terminalplatine 1 bzw. auf der Logikplatine 4 gestatten.

Sowohl Terminalplatine 1 als auch Logikplatine 4 werden über nicht dargestellte Anschlußkontakte mit Signalspannungen versorgt, so daß die elektrischen Signale auf der Logikplatine 4 mittels einer Logikplatinen-Signalspannung und die elektrischen Signale auf der Terminalplatine 1 mittels einer Terminalplatinen-Signalspannung verarbeitet werden. Mittels der nicht dargestellten Zwischenschaltung der Verbindungsplatine 5 ist dann eine Signalspannungsumsetzung zwischen der Logikplatinen-Signalspannung einerseits und der Terminalplatinen-Signalspannung andererseits realisiert. Häufig liegt die Logikplatinen-Signalspannung in Größenordnungen von 5-24 V, während im Falle der Terminalplatinen-Signalspannung Werte im Bereich von 24-230 V üblich sind.

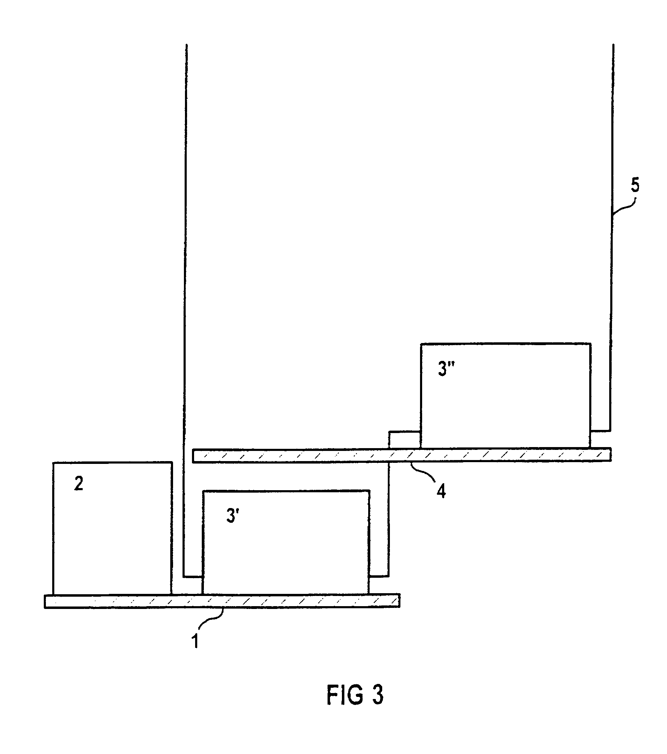

Aus FIG 3 ist ersichtlich, daß Terminalplatine 1 und Logikplatine 4 im Gehäuse höhenversetzt in zueinander parallelen Ebenen angeordnet sind. Dadurch überlappen sich im verbundenen Zustand die Terminalplatine 1 und die Logikplatine 4, so daß ein äußerst platzsparender Aufbau möglich ist. Die Logikplatine 4 überlappt die Terminalplatine 1 vorzugsweise in dem Bereich, in dem die Steckverbinder 3' auf der Terminalplatine 1 aufgebracht sind und damit in einem Bereich, in dem auf der Terminalplatine 1 nur eine vernachlässigbar geringe Wärmeabstrahlung entsteht. Die Verbindungsplatinen 5 stehen auf der Logikplatine 4 im wesentlichen senkrecht. Aus diesem Grunde ist die Wärmeableitung von nicht dargestellten Bauteilen, die sich in der nicht dargestellten Logikschaltung auf der Logikplatine 4 befinden, durch die Verbindungsplatinen 5 nicht behindert. Weiterhin ist es aufgrund des dreidimensionalen Aufbaus möglich, auf den senkrecht stehenden Platinen wärmeerzeugende Bauteile in größerem Abstand zu wärmeempfindlichen Bereichen der waagerechten Platinen anzuordnen. Es ergeben sich somit vorteilhafte Bedingungen für die Entwärmung des Gerätes, bei dem im Vergleich mit anderen Geräten bei gleicher Gesamtverlustleistung das Gesamtvolumen geringer gehalten werden kann. Dabei können die Verbindungsplatinen 5 auch in anderen Winkeln - im wesentlichen durch die Art der Steckverbinder 7 festgelegt - zu der Terminalplatine 1 bzw. der Logikplatine 4 stehen.

Im dargestellten Beispiel gemäß FIG 1 weist nur die Terminalplatine 1 Anschlußmittel 2 für von außen heranführbare Leitungen auf. Dies ist über die bereits genannten Vorteile hinaus nützlich, weil aus diesem Grunde das nicht dargestellte Gehäuse nur auf der Seite der Terminalplatine 1, insbesondere im Bereich der Anschlußelemente 2, entsprechende Öffnungen bzw. Ausnehmungen aufweisen muß, mit denen ein Betätigen der Anschlußelemente 2 bzw. ein Einführen von nicht dargestellten externen Leitungen möglich ist. Eine nicht dargestellte eventuelle Abschirmung, die die gesamte Schaltungsanordnung umschließt, die daher insbesondere auf der Innenseite des nicht dargestellten Gehäuses aufgebracht ist, muß damit nur an wenigen definierten Stellen durchbrochen werden.

Wenn die Verbindungsplatinen 5 - wie in FIG 1 dargestellt bzw. in FIG 2 durch die Anordnung der SMD-Steckverbinderelemente 7 angedeutet - jeweils paarweise angeordnet sind, so kann die Zwischenschaltung der Verbindungsplatinen 5 so ausgelegt sein, daß jeweils eine Verbindungsplatine 5 die Funktion einer bestimmten Gruppe von Anschlußmitteln 2 festlegt, wobei diese Gruppe von Anschlußmitteln 2 insbesondere direkt mit dem Layout der innerhalb der Logikschaltung verarbeiteten Daten korrespondiert. Eine Gruppe von digitalen Ausgangssignalen ist dann beispielsweise bei der Verarbeitung in der Logikschaltung zu einem Ausgangsbyte zusammengefaßt.

Dabei besteht ein Ausgangsbyte aus 8 einzelnen Ausgangs-Bits, denen jeweils digitale Ausgangssignale zugeordnet sind. Die Zwischenschaltung der Verbindungsplatine 5 leitet damit genau diese 8 Ausgangssignale des Ausgangsbytes an die entsprechenden 8 Anschlußmittel 2 der Terminalplatine 1. Die andere Verbindungsplatine 5 der paarweisen Anordnung leitet analog die 8 Ausgangssignale eines anderes Ausgangsbytes an die entsprechenden 8 anderen Anschlußmittel 2 der Terminalplatine 1. Damit ist das Layout der in der Logikschaltung verarbeiteten Daten direkt auf die Anschlußmittel 2 der Terminalplatine 1 abgebildet. Die Anzahl der zu einer Gruppe zusammengefaßten Eingangs-/Ausgangssignale ist häufig ein ganzzahliges Vielfaches von 8. Entsprechend ergibt sich innerhalb der Logik-schaltung eine byte-weise, wort-weise, langwort-weise, etc. Verarbeitung. Die Anzahl und die Anordnung der Anschlußmittel 2 auf der Terminalplatine 1 korrespondiert vorteilhafterweise jeweils mit dem Layout der in der Logik-schaltung verarbeiteten Daten.

Die erfindungsgemäße Baugruppe eignet sich vor allem für solche Anwendungsfälle, in denen es darum geht, einerseits externe Signale eines Prozesses aufzunehmen, oder andererseits Steueranweisungen oder Daten an einen Prozeß auszugeben. Aufgrund der Modularisierung ist die Baugruppe wartungsfreundlich und zeichnet sich durch eine hohe Verfügbarkeit aus.

Die Baugruppe kann insbesondere als dezentrales Automatisierungsgerät eingesetzt werden. Dabei ist es möglich und vorteilhaft, die Baugruppe auch in räumlicher Nähe zu dem zu steuernden und/oder zu überwachenden Teil des Prozesses anzuordnen. Der Anschluß der Prozeßelemente läßt sich damit insbesondere mit geringen Kabellängen realisieren.

Die als dezentrales Automatisierungsgerät eingesetzte Baugruppe ist mit einem zentralen Automatisierungsgerät in an sich bekannter Weise verbindbar und kann mit diesem Daten austauschen. Die Baugruppe übernimmt in diesem Falle also gleichsam die Funktion einer Schnittstelle zwischen zentralem Automatisierungsgerät und Prozeß.

Die Baugruppe kann weiterhin insbesondere zur Entlastung des zentralen Automatisierungsgerätes beitragen, indem sie
- eine Vorverarbeitung der vom Prozeß eingelesenen Daten durchführt,
- gewisse Funktionen des Teilprozesses auch unabhängig vom zentralen Automatisierungsgerät überwacht und steuert,
- nur relevante Daten an das zentrale Automatisierungsgerät weiterleitet und dieses damit entlastet,
- vom zentralen Automatisierungsgerät empfangene Daten aufbereitet und an den Teilprozeß ausgibt.

## Patentansprüche

1. Baugruppe mit einer Schaltungsanordnung mit zumindest einer ersten Platine (1), einer mit der ersten Platine (1) nicht direkt verbundenen zweiten Platine (4) und einer sowohl mit der ersten (1) als auch mit der zweiten Platine (4) verbundenen dritten Platine (5),
**dadurch gekennzeichnet,**
- daß die zweite Platine (4) und die dritte Platine (5) in einem gemeinsamen Gehäuse angeordnet sind,
- daß die erste Platine (1) eine Terminalplatine (1) ist, welche zumindest Anschlußmittel (2), z.B. Klemmen, für von außen heranführbare Leitungen aufweist,
- wobei an den Anschlußmitteln (2) je nach deren Funktion Eingangssignale von externen Sensoren bzw. Ausgangssignale für externe Aktoren anlegbar sind,
- daß die zweite Platine (4) eine Logikplatine (4) ist, welche zumindest eine Logikschaltung aufweist,
- daß die dritte Platine (5) eine Verbindungsplatine (5) ist, welche zumindest eine Zwischenschaltung aufweist,
- wobei die Zwischenschaltung sowohl mit der Logikschaltung als auch mit zumindest Teilen der Anschlußmittel (2) verbunden ist und die Funktion der Anschlußmittel (2) festlegt,
- so daß je nach Funktion der Anschlußmittel (2) entweder Eingangssignale über die Anschlußmittel (2) mittels der Zwischenschaltung der Logikschaltung zuführbar sind oder Ausgangssignale von der Logikschaltung mittels der Zwischenschaltung an die Anschlußmittel (2) ausgebbar sind und
- mittels der Zwischenschaltung der Verbindungsplatine (5) eine Signalspannungsumsetzung zwischen einer Logikplatinen-Signalspannung einerseits, mit der die elektrischen Signale auf der Logikplatine (4) verarbeitet werden, und einer Terminalplatinen-Signalspannung andererseits, mit der die elektrischen Signale auf der Terminalplatine (1) verarbeitet werden, realisiert ist.

2. Baugruppe nach Anspruch 1, **dadurch gekennzeichnet**, daß auch die Terminalplatine (1) in dem gemeinsamen Gehäuse angeordnet ist.

3. Baugruppe nach einem der obigen Ansprüche, **dadurch gekennzeichnet**, daß die elektrische Verbindung zwischen Verbindungsplatine (5) und Terminalplatine (1) durch einen Steckverbinder (3'), insbesondere einem SMD-Steckverbinder (7), erfolgt.

4. Baugruppe nach einem der obigen Ansprüche, **dadurch gekennzeichnet**, daß die elektrische Verbindung zwischen Verbindungsplatine (5) und Logikplatine (4) durch einen Steckverbinder (3"), insbesondere einen SMD-Steckverbinder (7), erfolgt.

5. Baugruppe nach einem der obigen Ansprüche, **dadurch gekennzeichnet**, daß die Anzahl der innerhalb der Baugruppe verwendeten Verbindungsplatinen (5) geradzahlig ist und daß diese Verbindungsplatinen (5) paarweise angeordnet sind.

6. Baugruppe nach einem der obigen Ansprüche, **dadurch gekennzeichnet**, daß
- die Terminalplatine (1) im wesentlichen nur die Anschlußmittel (2) für von außen heranführbare Leitungen und insbesondere keine Logikschaltung aufweist und
- die Logikplatine (4) im wesentlichen nur die Logikschaltung und insbesondere keine Anschlußmittel (2) für von außen heranführbare Leitungen aufweist.

## Claims

1. Module having a circuit arrangement having at least a first board (1), a second board (4) which is not directly connected to the first board (1), and a third board (5) which is connected to both the first board (1) and also the second board (4), characterised
- in that the second board (4) and the third board (5) are arranged in a common housing,
- in that the first board (1) is a terminal board (1) which has at least connection means (2), for example terminals, for lines which can be led in from the outside,
- wherein there can be applied to the connection means (2), depending on the function thereof, input signals of external sensors or output signals for external actuators,
- in that the second board (4) is a logic board, which has at least one logic circuit,
- in that the third board (5) is a connection board (5) which has at least one intermediate circuit,
- wherein the intermediate circuit is connected both to the logic circuit and also to at least parts of the connection means (2) and fixes the function of the connection means (2),
- so that depending on the function of the connection means (2), either input signals can be supplied to the logic circuit via the connection means (2) by means of the intermediate circuit, or output signals from the logic circuit can be output by means of the intermediate circuit to the connection means (2),
- by means of the intermediate circuit of the connection board (5), a signal voltage conversion between, on the one hand, a logic-board signal voltage, with which the electrical signals are processed on the logic board (4) and, on the other hand, a terminal-board signal voltage, with which the electrical signals are processed on the terminal board (1) is realised.

2. Module according to claim 1, characterised in that the terminal board (1) is also arranged in the common housing.

3. Module according to one of the above claims, characterised in that the electrical connection between connection board (5) and terminal board (1) takes place by means of a plug-in connector (3'), in particular an SMD plug-in connector (7).

4. Module according to one of the above claims, characterised in that the electrical connection between connection board (5) and logic board (4) takes place by means of a plug-in connector (3"), in particular an SMD plug-in connector (7).

5. Module according to one of the above claims, characterised in that the number of connection boards (5) used inside the module is even-numbered and in that these connection boards (5) are arranged in pairs.

6. Module according to one of the above claims, characterised
- in that the terminal board (1) has substantially only the connection means (2) for lines which can be led in from the outside and in particular does not have a logic circuit, and
- in that the logic board (1) has substantially only the logic circuit and in particular does not have any connection means (2) for lines to be led in from the outside.

## Revendications

1. Module ayant un ensemble de circuits, comportant au moins une première carte (1), une deuxième carte (4) non directement assemblée à la première carte (1), et une troisième carte (5) assemblée tant à la première carte (1) qu'à la deuxième carte (4),
caractérisé
- en ce que la deuxième carte (4) et la troisième carte (5) sont disposées dans un boîtier commun,
- en ce que la première carte (1) est une carte (1) terminale, qui comporte au moins des moyens (2) de connexion, par exemple des bornes, pour des lignes pouvant être amenées de l'extérieur,
- des signaux d'entrée de capteurs externes ou des signaux de sortie pour des actionneurs externes pouvant être appliqués aux moyens (2) de connexion, suivant la fonction de ces derniers,
- en ce que la deuxième carte (4) est une carte (4) logique, qui comporte au moins un circuit logique,
- en ce que la troisième carte (5) est une carte (5) de liaison, qui comporte au moins un circuit intermédiaire,
- le circuit intermédiaire étant relié à la fois au circuit logique et à au moins une partie des moyens (2) de connexion et définissant la fonction des moyens (2) de connexion,
- de sorte que, suivant la fonction des moyens (2) de connexion, soit des signaux d'entrée peuvent être apportés par les moyens (2) de connexion au circuit logique à l'aide du circuit intermédiaire, soit des signaux de sortie peuvent être délivrés par le circuit logique aux moyens (2) de connexion à l'aide du circuit intermédiaire,
et
- le circuit intermédiaire de la carte (5) de liaison réalise une conversion de tension de signalisation entre, d'une part, une tension de signalisation pour cartes logiques, avec laquelle sont traités les signaux électriques sur la carte (4) logique, et, d'autre part, une tension de signalisation pour cartes terminales, avec laquelle sont traités les signaux électriques sur la carte (1) terminale.

2. Module suivant la revendication 1, caractérisé en ce que la carte (1) terminale est elle aussi disposée dans le boîtier commun.

3. Module suivant l'une des revendications précédentes, caractérisé en ce que la liaison électrique entre la carte (5) de liaison et la carte (1) terminale s'effectue par un connecteur (3') enfichable, notamment un connecteur (7) enfichable CMS.

4. Module suivant l'une des revendications précédentes, caractérisé en ce que la liaison électrique entre la carte (5) de liaison et la carte (4) logique s'effectue par un connecteur (3") enfichable, notamment un connecteur (7) enfichable CMS.

5. Module suivant l'une des revendications précédentes, caractérisé en ce que le nombre de cartes (5) de liaison utilisées dans le module est pair, et en ce que ces cartes (5) de liaison sont disposées par paires.

6. Module suivant l'une des revendications précédentes, caractérisé en ce que
- la carte (1) terminale comporte pour l'essentiel uniquement les moyens (2) de connexion pour des lignes pouvant être amenées de l'extérieur, et notamment ne comporte pas de circuit logique, et
- la carte (4) logique comporte pour l'essentiel uniquement le circuit logique, et notamment ne comporte pas de moyens (2) de connexion pour des lignes pouvant être amenées de l'extérieur.
